# DEMANDE DE BREVET EUROPEEN

(11) **EP 2 337 032 A1**
(43) Date de publication de la demande: **22.06.2011**
(21) Numéro de dépôt: 10193774.6
(22) Date de dépôt: 06.12.2010
(51) Int. Cl.: G11C 16/10, G11C 16/30

(54) **Procédé de programmation d'un point-mémoire du type non-volatile électriquement programmable et effaçable et dispositif de mémoire correspondant**

(30) Priorité: 11.12.2009 FR 0958868
(71) Demandeur: STMicroelectronics (Rousset) SAS, 13790 Rousset (FR)
(72) Inventeur: Tailliet, François, 13710 Fuveau (FR)
(74) Mandataire: Zapalowicz, Francis

(57) **Abrégé**

Le point-mémoire du type non volatile électriquement programmable et effaçable comporte au moins un transistor à grille flottante relié à une ligne de bit et à une ligne de masse (BGND), et programmable avec une tension de programmation (Vpp). Au cours d'une phase d'effacement du point-mémoire on applique une première tension négative (V-) définie par rapport au potentiel du substrat des transistors mémoire sur la ligne de bit (BL) et sur la ligne de masse (BGND), la valeur absolue de cette première tension (V-) étant inférieure à la valeur de seuil d'une diode PN, tandis qu'on applique une deuxième tension positive (V2) définie aussi par rapport au potentiel du substrat des transistors mémoire sur la grille de commande (CG) du transistor à grille flottante (TGF) de valeur inférieure à ladite tension de programmation, la différence entre ladite deuxième tension (V2) et ladite première tension (V-) étant égale à ladite tension de programmation, et au cours d'une phase d'écriture du point-mémoire (PTM) on applique ladite première tension négative (V-) sur la grille de commande du transistor à grille flottante (TGF) et la deuxième tension (V2) sur la ligne de bit.

## Description

L'invention concerne les mémoires, en particulier les mémoires non volatiles de type électriquement effaçable et programmable (EEPROM).

Dans les mémoires EEPROM, la valeur logique d'un bit stocké dans un point-mémoire est représentée par la valeur de la tension de seuil d'un transistor à grille flottante, qui peut être modifiée à volonté par des opérations d'écriture ou d'effacement. L'écriture ou l'effacement d'un transistor à grille flottante consiste dans l'injection ou l'extraction des charges électriques dans la grille du transistor par effet tunnel (effet « Fowler-Nordheim ») au moyen d'une haute tension de programmation Vpp qui peut être de l'ordre de 10 à 20 volts, typiquement 16 volts.

Cette haute tension de 16 volts, nécessaire pour la programmation des mémoires EEPROM est non réductible et est très contraignante au niveau de la filière technologique et de la fiabilité du produit.

En effet, la réduction lithographique, c'est-à-dire l'augmentation de la finesse de gravure, conduit à une diminution des tensions de fonctionnement, et cette haute tension de programmation devient plus problématique en termes notamment de perçage et des fuites des jonctions source/drain des transistors ainsi qu'en terme de claquage des oxydes de grille.

Par conséquent, ces risques de claquage et de vieillissement prématuré des transistors ont un impact direct sur la fiabilité du produit.

Une solution, dite « de tension partagée » ou « split voltage » selon une dénomination anglosaxonne habituellement utilisée par l'homme du métier, a été envisagée. Plus précisément, la haute tension Vpp nécessaire à la programmation des plans-mémoires est partagée entre une tension positive Vpp+ et une tension négative Vpp- de sorte que la différence (Vpp+ - Vpp-) soit égale à Vpp. Ainsi, dans une telle approche, on choisira une tension Vpp+ de l'ordre de 12 volts et une tension Vpp- de l'ordre de -4 volts.

Une telle solution permet un relâchement de la contrainte sur la tenue en tension des transistors. Cependant, elle présente l'inconvénient de rendre plus compliqué le procédé de fabrication des plans-mémoires puisqu'il nécessite une technologie dite « triple caisson » en raison de la tension négative de l'ordre de quelques volts. Par ailleurs, la conception de la commande est plus compliquée puisqu'il est nécessaire de prévoir des commutations de tension négative, ce qui a également un impact négatif sur la surface du plan-mémoire. En effet, une commutation de tension négative s'avère coûteuse en place dans le plan-mémoire (utilisation de transistors PMOS) au niveau des transistors de sélection des grilles de commande, et se prête mal à la faible granularité des mémoires EEPROM.

Selon un mode de mise en oeuvre et de réalisation, il est proposé un procédé de programmation d'un point-mémoire du type non volatile électriquement programmable et effaçable, et un dispositif de mémoire correspondant compatible avec l'approche classique de réalisation des mémoires de ce type (c'est-à-dire ne nécessitant notamment pas de modification de la filière technologique et compatible avec une granularité par octets), tout en permettant une réduction de la contrainte technologique sur la tenue en tension des transistors et un gain important sur la fiabilité par une réduction du risque de claquage d'oxyde.

Selon un aspect, il est proposé un procédé de programmation d'un point-mémoire du type non volatile électriquement programmable et effaçable comportant au moins un transistor à grille flottante relié à une ligne de bit et à une ligne de masse, et programmable avec une tension de programmation.

Selon une caractéristique générale de cet aspect, au cours d'une phase d'effacement du point-mémoire, on applique une première tension négative sur la ligne de bit et sur la ligne de masse, la valeur absolue de cette première tension étant inférieure à la valeur de seuil d'une diode PN, tandis qu'on applique une deuxième tension positive sur la grille de commande du transistor à grille flottante de valeur inférieure à ladite tension de programmation, la différence entre ladite deuxième tension et ladite première tension étant égale à ladite tension de programmation, et
au cours d'une phase d'écriture du point-mémoire, on applique ladite première tension négative sur la grille de commande du transistor à grille flottante et la deuxième tension sur la ligne de bit.

L'inventeur a en effet observé qu'une faible variation de la tension de programmation était suffisante pour avoir un effet considérable (exponentiel) sur la fiabilité des points-mémoires en ce qui concerne le claquage des oxydes de grille.

Par ailleurs, le fait d'utiliser une tension négative inférieure à la valeur de seuil d'une diode PN, par exemple une tension négative de l'ordre de 500 millivolts, permet non seulement d'obtenir cet effet considérable sur la fiabilité des points-mémoires tout en étant compatible avec une filière classique de fabrication des points-mémoires EEPROM, utilisant par exemple une technologie « simple caisson ». En effet, cette faible tension négative reste compatible avec une telle technologie car elle permet d'éviter la mise en avalanche des jonctions PN.

En outre, dans la phase d'effacement, le point-mémoire court-circuite la ligne de bit et la ligne de masse. Le fait d'appliquer la tension négative simultanément sur la ligne de bit et la ligne de masse (au lieu d'appliquer classiquement la masse (c'est-à-dire 0 volt sur la ligne de masse)) évite un court-circuit entre la tension négative et 0 volt.

Dans ce qui précède la tension négative et la tension positive sont définies par rapport au potentiel de substrat du ou des transistors.

Dans un mode de mise en oeuvre, dans lequel le transistor à grille flottante est un transistor MOS de type de conductivité N réalisé dans une technologie du type « simple caisson », on applique une première tension négative de l'ordre de -0,5 volt tandis qu'on applique une deuxième tension positive de l'ordre de 15,5 volts. Avec ces valeurs, on retrouve bien une tension de programmation de 16 volts.

Ainsi, dans un tel exemple, on envoie donc -0,5 volt sur la ligne de bit et sur la ligne de masse pendant la phase d'effacement tandis qu'on envoie -0,5 volt sur la grille de commande du transistor à grille flottante pendant la phase d'écriture.

Selon un autre aspect, il est proposé un dispositif de mémoire comprenant un plan-mémoire possédant au moins un point mémoire du type non volatile électriquement programmable et effaçable comportant au moins un transistor à grille flottante relié à une ligne de bit et à une ligne de masse, et des moyens de programmation du point-mémoire configuré pour programmer le point mémoire avec une tension de programmation.

Selon une caractéristique générale de cet aspect, les moyens de programmation comprennent
- des premiers moyens configurés pour générer une première tension négative dont la valeur absolue est inférieure à la valeur de seuil d'une diode PN,
- des deuxièmes moyens configurés pour générer une deuxième tension positive inférieure à la tension de programmation, la différence entre ladite deuxième tension et ladite première tension étant égale à ladite tension de programmation, et
- des moyens de contrôle configurés pour appliquer la première tension négative sur la ligne de bit et sur la ligne de masse et la deuxième tension positive sur la grille de commande du transistor à grille flottante au cours d'une phase d'effacement du point mémoire, et pour appliquer ladite première tension négative sur la grille de commande et la deuxième tension sur la ligne de bit au cours d'une phase d'écriture du point mémoire.

Les premiers moyens peuvent comporter un circuit de pompe de charge négative.

Selon un mode de réalisation, le circuit de pompe de charge négative comporte une entrée pour recevoir une tension de commande, une sortie pour délivrer la première tension négative, un premier condensateur connecté à l'entrée, une première diode connectée entre le premier condensateur et la masse, un deuxième condensateur connecté entre la sortie et la masse, une diode de transfert de charge connectée entre les deux condensateurs, une deuxième diode connectée entre la diode de transfert et la masse.

Selon un mode de réalisation, les moyens de contrôle comportent
- un commutateur possédant une entrée connectée à la sortie des premiers moyens, une première sortie, une deuxième sortie, une troisième sortie et un circuit de commande configuré
■ pour recevoir un signal logique de programmation possédant une première valeur logique représentative d'une programmation et un signal logique d'écriture/effacement possédant une première valeur logique représentative d'un effacement, une deuxième valeur logique représentative d'une écriture, et
■ pour relier la première sortie à l'entrée et la troisième sortie à la masse en présence de la première valeur logique du signal logique de programmation et de la deuxième valeur logique du signal d'écriture/effacement, et
■ pour relier la première sortie à la masse et la troisième sortie à l'entrée en présence de la première valeur logique du signal logique de programmation et de la première valeur logique du signal d'écriture/effacement, - un interrupteur connecté entre la deuxième sortie du commutateur et la ligne de masse, commandable par le signal d'écriture/effacement de façon à être passant lorsque le signal d'écriture/effacement possède sa première valeur logique, c'est-à-dire en effacement,
- un premier translateur de niveau commandable par le signal logique d'écriture/effacement, possédant une entrée connectée à la première sortie du commutateur et une sortie connectée à ladite grille de commande,
- un deuxième translateur de niveau commandable par le complément du signal logique d'écriture/effacement, possédant une entrée connectée à la troisième sortie du commutateur et une sortie connectée à ladite ligne de bit.

Ainsi, lors de l'effacement du plan-mémoire, la tension de sortie de la pompe de charge est envoyée sur les lignes de masse internes au plan-mémoire et se substitue au potentiel 0 volt classique.

De même, la tension de sortie de la pompe de charge est envoyée sur l'entrée du translateur de niveau affecté à la grille de commande du transistor à grille flottante lors de l'écriture et se substitue au potentiel 0 volt classique.

Selon un mode de réalisation, le plan mémoire est un plan-mémoire matriciel comportant plusieurs points-mémoire, et les moyens de programmation comportent un bloc de premières mémoires-verrous connectées entre la sortie du premier translateur de niveau et les grilles de commande des points mémoire et un bloc de deuxièmes mémoires-verrous connectées entre la sortie du deuxième translateur de niveau et les lignes de bits reliées aux points mémoire.

Le plan-mémoire peut être un plan-mémoire de type EEPROM ou Flash et ne comporter que des transistors NMOS réalisés en technologie simple caisson.

D'autres avantages et caractéristiques de l'invention apparaîtront à l'examen de la description détaillée de modes de mise en oeuvre et de réalisation, nullement limitative, et des dessins annexés :
- la figure 1 illustre schématiquement un exemple de réalisation d'un point-mémoire du type EEPROM ;
- la figure 2 illustre schématiquement une technologie « simple caisson » ;
- la figure 3 illustre schématiquement un mode de réalisation d'un dispositif de mémoire selon l'invention, et ;
- les figures 4 à 13 illustrent schématiquement mais plus en détails certaines parties du dispositif de mémoire de la figure 3 ainsi que leur mode de fonctionnement dans des phase d'écriture ou d'effacement des plans-mémoires.

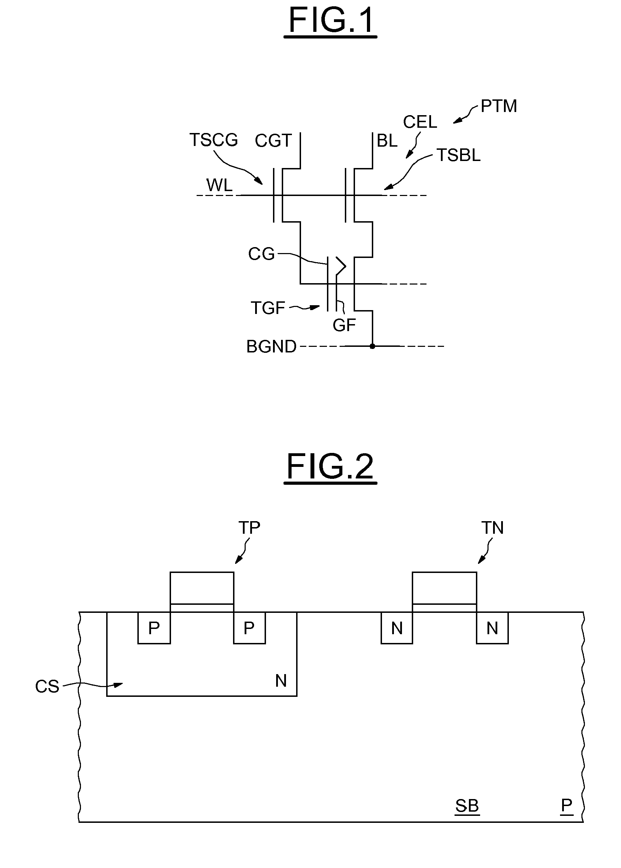

Un exemple d'architecture de points-mémoires est illustré sur la figure 1.

Sur cette figure, le point-mémoire PTM comporte une cellule-mémoire CEL comportant un transistor TGF ayant une grille de commande CG et une grille flottante GF. La cellule CEL est connectée à une ligne de bit BL par l'intermédiaire d'un transistor de sélection de ligne de bit TSBL.

La cellule comporte par ailleurs un transistor de sélection de grille de commande TSCG connecté entre une ligne de commande de grille CGT et la grille de commande CG du transistor à grille flottante TGF.

Les grilles des transistors TSCG et TSBL sont reliées à une ligne de mots WL s'étendant classiquement perpendiculairement à la ligne de bit BL.

La source du transistor TGF est connectée à une ligne de masse BGND.

L'architecture de la figure 1 prévoit donc ici une cellule-mémoire par bit.

Ce point-mémoire peut être programmé, c'est-à-dire écrit ou effacé, ou bien lu.

Généralement, on stocke dans la mémoire EEPROM des mots de x bits, typiquement huit bits, formant dans ce cas des octets. Typiquement, la zone de stockage d'un octet comporte donc huit points-mémoires plus un transistor de sélection de commande de grille TSCG (car généralement, les grilles de commande des huit cellules-mémoires des huit points-mémoires sont toutes connectées ensemble et sélectionnées à partir de la ligne CGT), ainsi qu'une ligne de masse BGND.

On verra plus en détails ci-après que cette ligne de masse BGND peut être connectée à une tension négative dans certains cas.

Une programmation d'un octet se compose d'un cycle d'effacement global pour le mot, suivi d'un cycle d'écriture sélectif.

Le point-mémoire PTM est formé de transistors NMOS qui sont ici réalisés de façon classique dans une technologie « simple caisson » illustrée par exemple sur la figure 2 de façon schématique.

Plus précisément, dans le cas où l'on a un substrat SB de type de conductivité P, les transistors NMOS TN sont réalisés directement dans le substrat SB tandis que les transistors PMOS TP sont réalisés dans un caisson CS de type N. Si l'on avait un substrat SB de type N, on aurait alors un seul caisson de type P dans lequel seraient réalisés les transistors NMOS tandis que les transistors PMOS seraient réalisés directement dans le substrat. Cette architecture à simple caisson se distingue notamment des architectures à triple caisson dans lesquelles les transistors NMOS sont réalisés au sein d'un caisson P, lui-même isolé par un caisson de type N réalisé dans un substrat de type P.

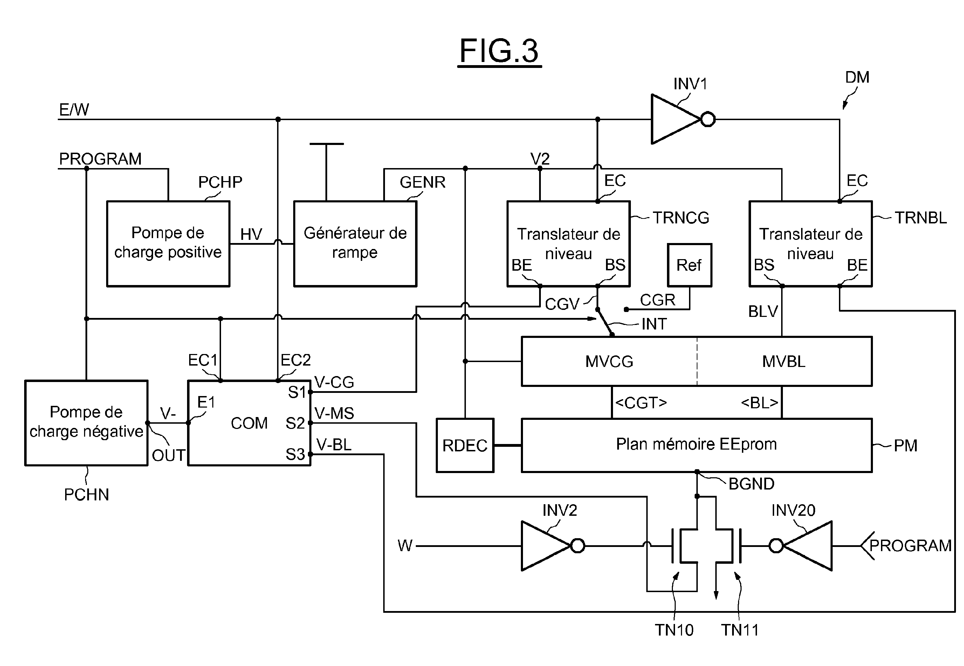

Sur la figure 3, on a représenté schématiquement un exemple d'architecture d'un dispositif-mémoire DM selon l'invention.

Ce dispositif-mémoire DM comporte ici un plan-mémoire PM du type EEPROM. Ce plan-mémoire est un plan-mémoire matriciel classique comportant dans cet exemple des lignes et des colonnes de points-mémoires PTM du type de ceux illustrés sur la figure 1. Les éléments classiques et connus en soi d'un tel dispositif de mémoire comportent notamment un décodeur de lignes RDEC, ainsi que des mémoires-verrous (« latch » selon une dénomination anglosaxonne bien connue de l'homme du métier) connectées aux lignes de commande CGT et aux lignes de bit BL. Les mémoires-verrous associées aux transistors de sélection de grille de commande sont référencées MVCG tandis que les mémoires-verrous associées aux lignes de bit sont référencées MVBL.

Ces mémoires-verrous reçoivent respectivement des tensions CGV et BLV délivrées par les bornes de sortie respectives BS de translateurs de niveau TRNCG et TRNBL respectivement associés aux grilles de commande des transistors à grille flottante et aux lignes de bit. Des moyens classiques de décodage colonnes, non représentés ici à des fins de simplification, sont également prévus et connectés au plan-mémoire PM.

Outre ces éléments, le dispositif de mémoire DM comporte un circuit de pompe de charge positif PCHP, de structure classique et connue en soi, délivrant une haute tension HV à un générateur de rampe GENR, également de structure classique et connue en soi.

Ce générateur de rampe délivre une haute tension positive V2, typiquement de l'ordre de 15,5 volts. Cette tension V2 est délivrée notamment aux translateurs de niveau TRNCG, TRNBL ainsi qu'au décodeur de ligne RDEC et aux mémoires-verrous MVCG et MVBL.

Outre ces éléments, le dispositif de mémoire comporte un circuit de pompe de charge négative PCHN délivrant, lorsqu'elle est activée en mode programmation par un signal de commande PROGRAM, une faible tension négative V-, par exemple de l'ordre de -500 millivolts.

La sortie OUT du circuit de pompe de charge négative PCHN est reliée à une entrée E1 d'un commutateur COM possédant trois sorties S1, S2, S3 délivrant respectivement des tensions V-CG, V-MS et V-BL.

Le commutateur COM comporte également deux entrées de commande EC1 et EC2 recevant respectivement le signal logique PROGRAM ainsi qu'un signal logique d'effacement/écriture référencé E/W.

Ce signal logique E/W est par ailleurs délivré à l'entrée de commande EC du translateur de niveau TRNCG ainsi qu'à l'entrée de commande EC du translateur de niveau TRNBL après avoir été inversé dans un inverseur INV1.

La première sortie S1 du commutateur est reliée à la borne d'entrée BE du translateur de niveau TRNCG tandis que la troisième sortie S3 du commutateur est reliée à la borne d'entrée BE du translateur de niveau TRNBL. La deuxième sortie S2 du commutateur est reliée à la ligne de masse interne BGND des points-mémoires PTM du plan-mémoire PM, par l'intermédiaire d'un transistor TN10 commandé sur sa grille par un signal logique W inversé dans un inverseur INV2. Le signal logique W est à « 1 » en mode « écriture » et à « 0 » en mode « effacement ».

De plus, le signal PROGRAM commande, par l'intermédiaire d'un inverseur INV20, un transistor TN11 connecté entre la ligne de masse interne BGND et la masse.

Enfin, un interrupteur INT, commandé par le signal PROGRAM permet de relier les mémoires-verrous MVCG soit à la sortie BS du translateur de niveau TRNCG en mode programmation, soit à la sortie d'une source de tension de référence Ref délivrant une tension de 1 volt par exemple en mode lecture.

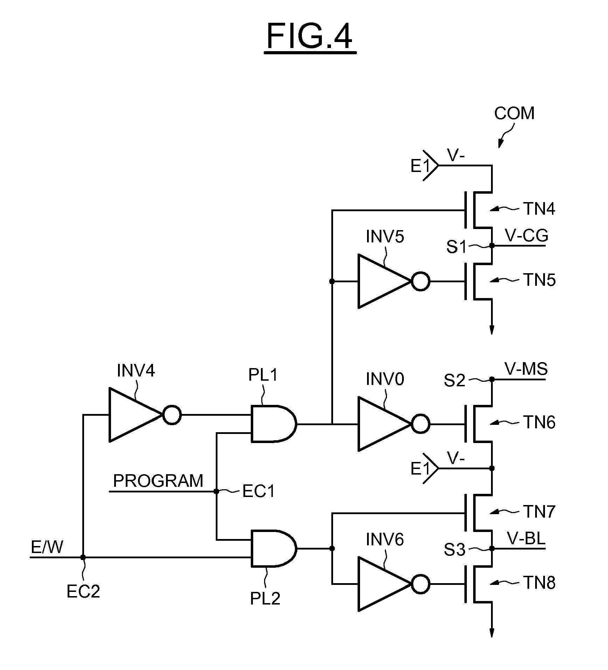

La figure 4 illustre un mode de réalisation, non limitatif, d'un bloc de commutation COM.

Plus précisément, la source d'un transistor NMOS TN4 forme l'entrée E1 du commutateur COM et le drain de ce transistor TN4 forme la première sortie S1. Le drain du transistor TN4 est relié au drain d'un autre transistor NMOS TN5 dont la source est reliée à la masse.

La grille du transistor TN4 est reliée à la sortie d'une porte logique ET référencée PL1, tandis que la grille du transistor TN5 est reliée également à la sortie de la porte logique PL1 par l'intermédiaire d'un inverseur INV5.

Le drain d'un autre transistor NMOS TN6 forme la deuxième sortie S2 du commutateur COM tandis que sa source est reliée à l'entrée E1.

La source du transistor TN6 est reliée à la source d'un transistor NMOS TN7 dont le drain forme la troisième sortie S3.

Le drain du transistor TN7 est relié au drain d'un transistor NMOS TN8 dont la source est reliée à la masse.

La grille du transistor TN6 est reliée à la sortie de la porte logique PL1 par l'intermédiaire d'un inverseur INV0 tandis que la grille du transistor TN7 est reliée à la sortie d'une autre porte logique ET référencée PL2.

La grille du transistor TN8 est reliée également à la sortie de la porte logique PL2 par l'intermédiaire d'un inverseur INV6.

Les deux premières entrées des portes logiques PL1 et PL2 sont reliées ensemble et forment la première entrée de commande EC1 du commutateur COM recevant le signal logique PROGRAM.

L'autre entrée de la porte logique PL2 forme la deuxième entrée de commande EC2 du commutateur COM recevant le signal logique E/W.

L'autre entrée de la porte logique PL1 est également liée à l'entrée de commande EC2 par l'intermédiaire d'un inverseur INV4.

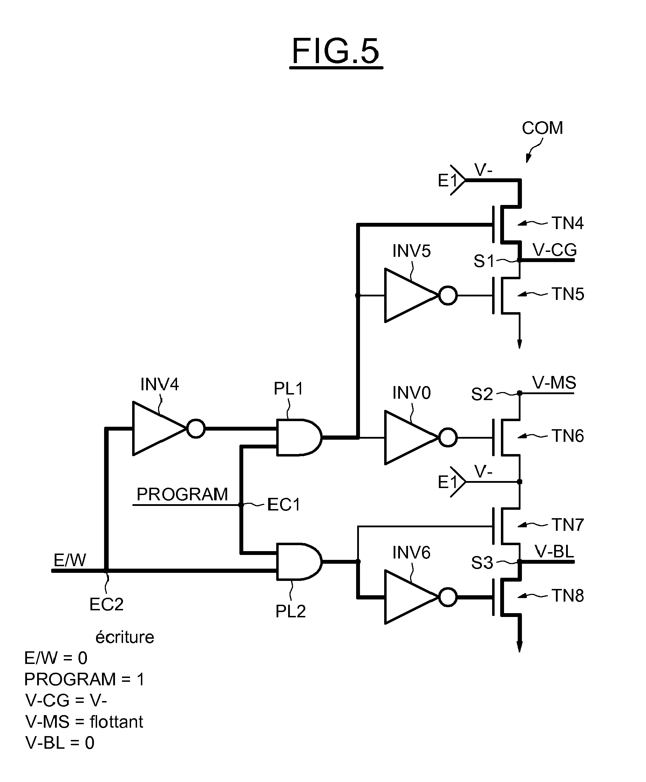

Dans une phase d'écriture, illustrée sur la figure 5, le signal logique E/W est égal par exemple à 0, tandis que le signal logique PROGRAM est égal à 1.

De ce fait, la sortie de la porte logique PL1 est égale à 1, ce qui rend passant le transistor TN4 et fournit par conséquent à la première sortie S1 une tension V-CG égale à la tension V- délivrée par le circuit de pompe de charge négative.

Le transistor TN6 est bloqué, ce qui laisse flottante la tension V-MS.

Par contre, la sortie de la porte logique PL2 est égale à 0, ce qui bloque le transistor TN7 et rend passant le transistor TN8, produisant donc à la sortie S3 une tension V-BL nulle (la sortie S3 est reliée à la masse).

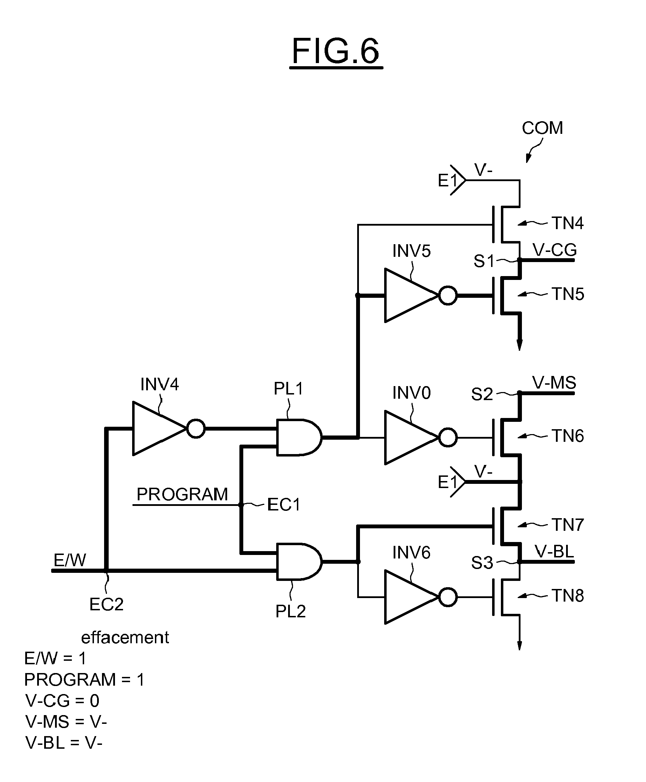

Par contre, dans une phase d'effacement (écriture d'un zéro), illustrée sur la figure 6, le signal logique E/W est égal à 1 tandis que le signal logique PROGRAM reste égal à 1.

Cette fois-ci, le transistor TN4 est bloqué et c'est le transistor TN5 qui est passant, reliant la sortie S1 à la masse et fournissant une tension V-CG nulle.

Le transistor TN6 est passant, ce qui permet de délivrer à la sortie S2 une tension V-MS égale à V-. Et, puisque en phase d'effacement, le signal logique W (figure 3) est égal à 0, le transistor TN10 est passant, et les lignes de masse internes BGND du plan-mémoire reçoivent la tension V-.

Le transistor TN7 est passant, ce qui permet de délivrer à la sortie S3 la tension V- délivrée par le circuit de pompe de charge négative.

Bien entendu, dans cette configuration, le transistor TN8 est bloqué.

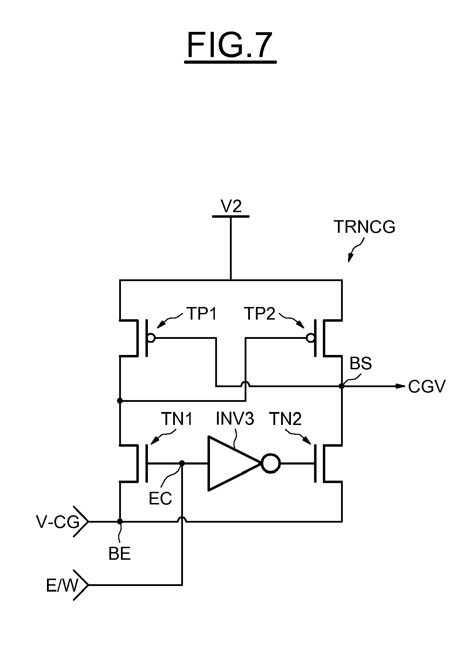

La figure 7 illustre un mode de réalisation d'un translateur de niveau TRNCG. Une telle structure est classique et non limitative.

Le translateur de niveau TRNCG comporte deux transistors PMOS TP1 et TP2 reliés de façon croisée. Plus précisément, la source de ces deux transistors PMOS TP1 et TP2 est reliée à la tension d'alimentation positive V2 tandis que la grille de l'un de ces transistors est reliée au drain de l'autre transistor et inversement.

Le drain du transistor TP2 forme la borne de sortie BS du translateur de niveau TRNCG.

Un transistor NMOS TN1 est relié entre le transistor PMOS TP1 et la borne d'entrée du translateur de niveau. De même, un transistor TN2 est relié entre la borne de sortie BS et la borne d'entrée BE. Les grilles des deux transistors TN1 et TN2 sont connectées ensemble par l'intermédiaire d'un inverseur INV3. L'entrée de l'inverseur INV3 forme l'entrée de commande EC du translateur de niveau et est destinée à recevoir le signal logique E/W.

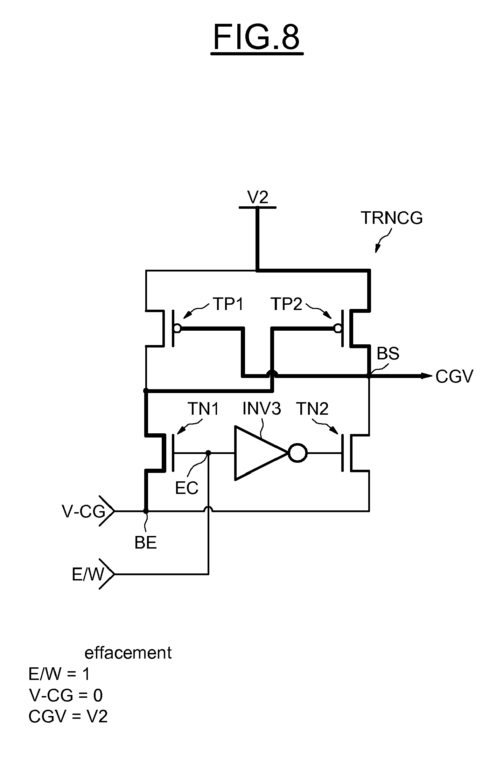

En effacement, c'est-à-dire lorsque le signal logique E/W est égal à 1 (figure 8), le transistor TN1 est passant. Puisque la tension V-CG est nulle, le transistor TP2 est passant, ce qui permet de délivrer à la borne de sortie BS une tension CGV égale à la tension V2. Les transistors TN1 et TN2 sont par ailleurs bloqués.

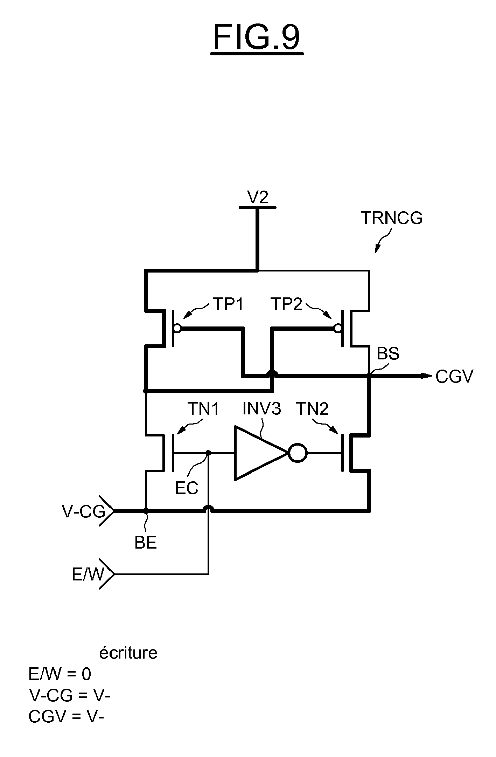

Dans la phase d'écriture (figure 9), le signal E/W est nul et la tension V-CG disponible à la borne d'entrée BE du translateur de niveau est égale à la tension V-.

Le transistor TN2 est passant, de même que le transistor TP1. I1 en résulte donc un blocage du transistor TP2 et une délivrance d'une tension CGV égale à la tension V-.

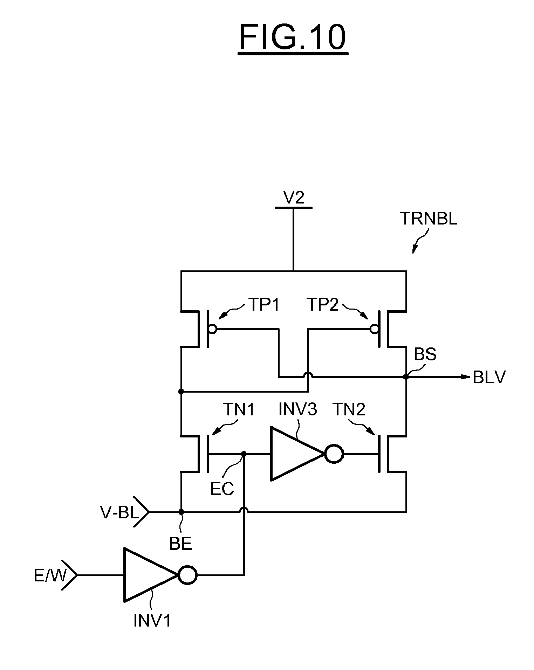

La structure d'un translateur de niveau TRNBL est illustrée sur la figure 10. Elle est ici strictement identique à celle du translateur de niveau TRNCG. La seule différence réside dans la commande de ce translateur de niveau TRNBL qui est inversée par rapport à la commande du translateur de niveau TRNCG, en raison de la présence de l'inverseur INV1.

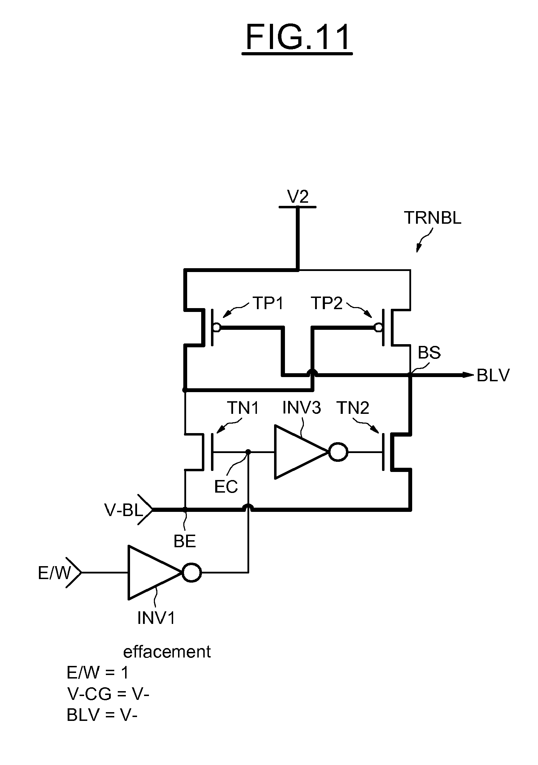

I1 en résulte donc, comme illustré sur la figure 11, que dans une phase d'effacement, la tension BLV délivrée à la borne de sortie BS du translateur de niveau TRNBL est égale à la tension V-.

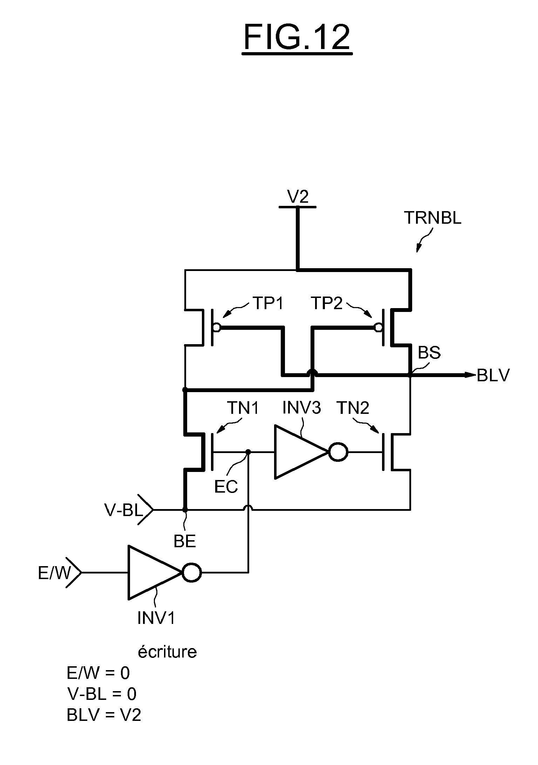

Par contre, en phase d'écriture (figure 12), la tension délivrée à la borne de sortie BS est égale à la tension V2.

Ainsi, on envoie la tension négative V-, par exemple -500 millivolts, sur les lignes de bit pendant la phase d'effacement tandis qu'on envoie cette tension négative sur les grilles de commande des transistors à grille flottante des points-mémoires pendant la phase d'écriture.

La tension négative délivrée par la pompe de charge est également envoyée sur les ligne de masse internes au plan-mémoire lors de l'effacement et se substitue ainsi au potentiel 0 volt classique. On évite ainsi un court-circuit entre la ligne de bit et la ligne de masse par l'intermédiaire du point-mémoire associé qui est effacé.

On voit qu'aucun autre changement, que ce soit dans le plan-mémoire, les mémoires-verrous, les décodeurs de lignes et de colonnes, n'est effectué.

Bien entendu, de façon classique le ou les points-mémoires réellement écrits, effacés ou lus, sont sélectionnés par l'intermédiaire de décodeurs de ligne et colonne.

En ce qui concerne le mode lecture (PROGRAM = 0), l'interrupteur INT est basculé vers la source de tension de référence Ref, et les lignes de masse internes BGND du plan-mémoire sont reliées à la masse (0 volt), comme cela est classique dans une EEPROM, puisque le transistor TN11 (figure 3) est passant.

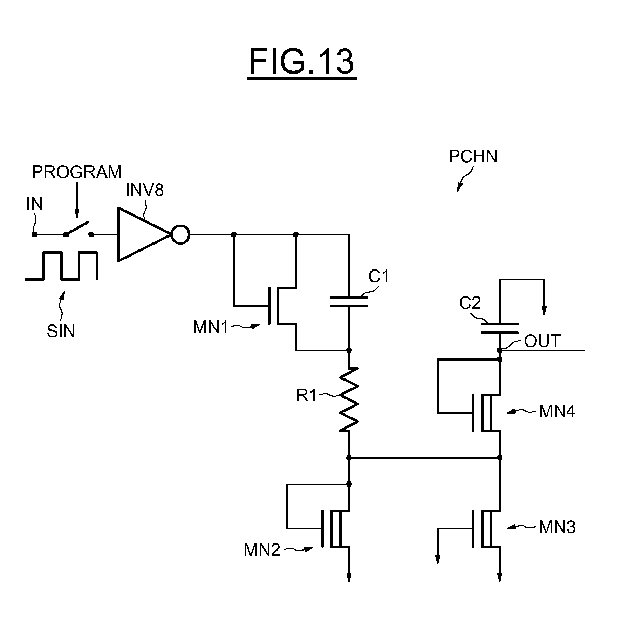

Le circuit de pompe de charge négative (figure 13) comporte une entrée IN pour recevoir une tension de commande SIN, qui est ici une tension en créneau 0-5 volts ayant une fréquence pouvant aller de quelques centaines de kHz à quelques dizaines de MHz.

La pompe de charge est activée par la valeur « 1 » du signal logique PROGRAM. Elle comporte un premier condensateur C1 connecté à l'entrée, une première diode MN2 connectée entre le premier condensateur et la masse, un deuxième condensateur C2 connecté entre la sortie OUT et la masse, et une diode de transfert de charge MN4 connectée entre les deux condensateurs et enfin une deuxième diode MN3 connectée entre la diode de transfert et la masse.

Un transistor MN1 limite la tension aux bornes du premier condensateur aux alentours de 0,9 volt, une tension plus élevée aux bornes du condensateur C1 étant inutile.

La résistance RI connectée entre le premier condensateur C1 et la diode MN2 limite le courant dans le transistor MN1 lors de la charge du premier condensateur C1, et dans la diode MN3 lors de la décharge du condensateur C1 dans le condensateur C2.

La diode MN3 permet d'éviter que la tension sur les sources et drains des transistors MN2, MN3 et MN4 descende à -0,6 volt, ce qui conduirait à une mise en direct des diodes avec le substrat et donc à un risque de dysfonctionnement.

La diode MN2 est réalisée ici par un transistor natif (c'est-à-dire un transistor n'ayant pas d'implant dans son canal) et ayant un seuil de l'ordre de 100 à 300 millivolts.

Bien que l'invention ait été décrite pour des points-mémoires à une cellule par bit, elle s'applique aussi à des points-mémoires à deux cellules par bit logique comportant donc deux transistors à grille flottante connectés respectivement à deux lignes de bits, ou bien à des points-mémoires du type comportant deux cellules-mémoires respectivement connectées à deux lignes de bits par l'intermédiaire de deux transistors de sélection de lignes de bits, la borne commune entre le transistor de sélection de ligne de bit et le transistor à grille flottante de chaque cellule-mémoire du point-mémoire étant connectée à la grille de commande du transistor à grille flottante de l'autre cellule-mémoire du point-mémoire, tels que décrits dans la demande de brevet français n° 0 957 623 au nom de la Demanderesse.

## Revendications

1. Procédé de programmation d'un point-mémoire du type non volatile électriquement programmable et effaçable comportant au moins un transistor à grille flottante relié à une ligne de bit et à une ligne de masse (BGND), et programmable avec une tension de programmation (Vpp), **caractérisé en ce qu'**au cours d'une phase d'effacement du point-mémoire on applique une première tension négative (V-) sur la ligne de bit (BL) et sur la ligne de masse (BGND), la valeur absolue de cette première tension (V-) étant inférieure à la valeur de seuil d'une diode PN, tandis qu'on applique une deuxième tension positive (V2) sur la grille de commande (CG) du transistor à grille flottante (TGF) de valeur inférieure à ladite tension de programmation, la différence entre ladite deuxième tension (V2) et ladite première tension (V-) étant égale à ladite tension de programmation, et au cours d'une phase d'écriture du point-mémoire (PTM) on applique ladite première tension négative (V-) sur la grille de commande du transistor à grille flottante (TGF) et la deuxième tension (V2) sur la ligne de bit.

2. Procédé selon la revendication 1, dans lequel le transistor à grille flottante (TGF) est un transistor MOS de type de conductivité N réalisé dans une technologie du type simple caisson, et on applique une première tension négative (V-) de l'ordre de -0,5 Volt tandis qu'on applique une deuxième tension positive (V2) de l'ordre de 15,5 Volts.

3. Dispositif de mémoire, comprenant un plan-mémoire (PM) possédant au moins un point mémoire (PTM) du type non volatile électriquement programmable et effaçable comportant au moins un transistor à grille flottante (TGF) relié à une ligne de bit (BL) et à une ligne de masse (BGND), et des moyens de programmation du point-mémoire configuré pour programmer le point-mémoire avec une tension de programmation (Vpp), **caractérisé en ce que** les moyens de programmation comprennent des premiers moyens (PCHN) configurés pour générer une première tension négative (V-) dont la valeur absolue est inférieure à la valeur de seuil d'une diode PN, des deuxièmes moyens (PCHP, GENR) configurés pour générer une deuxième tension positive (V2) inférieure à la tension de programmation (Vpp), la différence entre ladite deuxième tension et ladite première tension étant égale à ladite tension de programmation, et des moyens de contrôle (COM, TRNCG, TRNBL, TN10, TN11) configurés pour appliquer la première tension négative (V-) sur la ligne de bit (BL) et sur la ligne de masse (BGND) et la deuxième tension positive (V2) sur la grille de commande (CG) du transistor à grille flottante (TGF) au cours d'une phase d'effacement du point mémoire, et pour appliquer ladite première tension négative (V-) sur la grille de commande (CG) du transistor à grille flottante et la deuxième tension (V2) sur la ligne de bit au cours d'une phase d'écriture du point mémoire.

4. Dispositif selon la revendication 3, dans lequel le transistor à grille flottante (TGF) est un transistor MOS de type de conductivité N réalisé dans un substrat semi-conducteur selon une technologie du type simple caisson, et la première tension négative est de l'ordre de - 0,5 Volt tandis que la deuxième tension positive est de l'ordre de 15,5 Volts.

5. Dispositif selon la revendication 3 ou 4, dans lequel les premiers moyens (PCHN) comportent un circuit de pompe de charge négative.

6. Dispositif selon la revendication 5, dans lequel le circuit de pompe de charge négative comporte une entrée pour recevoir une tension de commande, une sortie pour délivrer la première tension négative, un premier condensateur connecté à l'entrée, une première diode connectée entre le premier condensateur et la masse, un deuxième condensateur connecté entre la sortie et la masse, une diode de transfert de charge connectée entre les deux condensateurs, une deuxième diode connectée entre la diode de transfert et la masse.

7. Dispositif selon l'une des revendications 3 à 6, dans lequel les moyens de contrôle comportent
- un commutateur (COM) possédant une entrée (E1) connectée à la sortie des premiers moyens (PCHN), une première sortie (S1), une deuxième sortie (S2), une troisième sortie (S3) et un circuit de commande configuré pour recevoir un signal logique de programmation (PROGRAM) possédant une première valeur logique (PROGRAM=1) représentative d'une programmation et un signal logique d'écriture/effacement (E/W) possédant une première valeur logique (E/W=1) représentative d'un effacement, une deuxième valeur logique (E/W=0) représentative d'une écriture, et pour relier la première sortie (S1) à l'entrée (E1) et la troisième sortie (S3) à la masse en présence de la première valeur logique (PROGRAM=1) du signal logique de programmation et de la deuxième valeur logique (E/W=0) du signal d'écriture/effacement, et pour relier la première sortie (S1) à la masse et les deuxième (S2) et troisième (S3) sorties à l'entrée (E1) en présence de la première valeur logique (PROGRAM=1) du signal logique de programmation et de la première valeur logique (E/W=1) du signal d'écriture/effacement, un interrupteur (TN10) connecté entre la deuxième sortie (S2) du commutateur et la ligne de masse (BGND), commandable par le signal d'écriture/effacement (E/W=1),
- un premier translateur de niveau (TRNCG) commandable par le signal logique d'écriture/effacement (E/W), possédant une entrée (BE) connectée à la première sortie (S1) du commutateur (COM) et une sortie (BS) connectée à ladite grille de commande (CG),
- un deuxième translateur de niveau (TRNBL) commandable par le complément du signal logique d'écriture/effacement (E/W), possédant une entrée (BE) connectée à la troisième sortie (S3) du commutateur et une sortie (BS) connectée à ladite ligne de bit (BL).

8. Dispositif selon l'une des revendications 3 à 7, dans lequel le plan-mémoire (PM) est un plan mémoire matriciel comportant plusieurs points-mémoire, et les moyens de programmation comportent un bloc de premières mémoires-verrous (MVCG) connectées entre la sortie du premier translateur de niveau et les grilles de commande des points mémoire et un bloc de deuxièmes mémoires-verrous (MVBL) connectées entre la sortie du deuxième translateur de niveau et les lignes de bits reliées aux points mémoire.

9. Dispositif selon l'une des revendications 3 à 8, dans lequel le plan-mémoire est de type EEPROM ou Flash.

10. Dispositif selon l'une quelconque des revendications 3 à 9, dans lequel tous les transistors du dispositif sont des transistors NMOS réalisés dans une technologie simple caisson.
